Europäisches Patentamt

European Patent Office

Office européen des brevets

(11) Veröffentlichungsnummer: **0 338 207**
**A1**

## EUROPÄISCHE PATENTANMELDUNG

(21) Anmeldenummer: 89102914.2

(51) Int. Cl.⁴: **H01L 21/306 , H01L 21/308**

(22) Anmeldetag: 20.02.89

(30) Priorität: 24.03.88 DE 3810022

(43) Veröffentlichungstag der Anmeldung:
25.10.89 Patentblatt 89/43

(84) Benannte Vertragsstaaten:
AT BE CH DE FR GB IT LI LU NL SE

(71) Anmelder: Siemens Aktiengesellschaft
Wittelsbacherplatz 2
D-8000 München 2(DE)

(72) Erfinder: Engelhardt, Manfred, Dr.
Edelweissstrasse 1a
D-8152 Feldkirchen-Westerham(DE)

(54) **Verfahren zum Erzeugen von Gräben in Siliziumsubstraten durch reaktives Ionenätzen bei der Herstellung höchstintegrierter Halbleiterschaltungen.**

(57) Das Verfahren sieht vor zur Erzeugung von Gräben (3) mit senkrechten bis leicht abgeschrägten glatten Wänden und abgerundeten Böden in Siliziumsubstraten (1) reaktives Ionenätzen unter Verwendung einer Ätzmaske (2) in einer Trifluorbrommethan- und stickstoffhaltigen Ätzgasatomosphäre in einem Einscheibenplattenreaktor durchzuführen. Dazu kann ein Trioden-Einscheibenplattenreaktor verwendet werden, wobei zwei verschiedene Hochfrequenzen eingestrahlt werden.

EP 0 338 207 A1

## Verfahren zum Erzeugen von Gräben in Siliziumsubstraten durch reaktives Ionenätzen bei der Herstellung höchstintegrierter Halbleiterschaltungen.

Die Erfindung betrifft ein Verfahren zum Erzeugen von Gräben in Siliziumsubstraten für höchstintegrierte Halbleiterschaltungen durch reaktives Ionenätzen in einer Tifluorbrommethan enthaltenden Ätzgasatmosphäre unter Verwendung einer Ätzmaske.

Für die Realisierung von 4 Mbit-Speichern wurden zur Erhöhung der Integrationsdichte Grabenzellen entwickelt, die als Speicherkondensatoren dreidimensionale Kondensatorstrukturen (Grabenkondensatoren) aufweisen. Da die Abmessungen einer Speicherzelle zu einem großen Teil durch die Abmessungen des Speicherkondensators bestimmt sind, können durch die Einführung des Grabenkondensators die Abmessungen einer Speicherzelle bei gleichbleibender Speicherkapazität verringert werden.

Aufgrund der geringen Abmessung von höchstens 1 $\mu m^2$ Querschnittsfläche und mindestens 4 bis 5 $\mu m$ Tiefe der Gräben werden zur Erzielung der erforderlichen Zuverlässigkeit der mechanischen und elektrischen Eigenschaften der Speicherzellen hoher Anforderungen an die Grabenprofile und die Beschaffenheit der Grabenwände gestellt. Die Grabenwände sollen senkrecht bis leicht abgeschrägt sein, damit ein hohlraumfreies Auffüllen der Gräben gewährleistet ist. Die hohlraumfreie Auffüllung ist Bedingung für die mechanische Stabilität und die Langzeitzuverlässigkeit der elektrischen Eigenschaften der Grabenzellen. Durch das Vermeiden einer merklichen Abschrägung des Grabenprofils kann eine maximale Kapazität des Grabenkondensators bei minimaler erforderlicher Grabentiefe erreicht werden. Darüber hinaus sollen die Grabenwände glatt sein und die Grabenböden abgerundet. Dadurch wird ein homogenes Erzeugen des die Grabenwände auskleidenden Dielektrikums, zum Beispiel eines Oxids, ermöglicht. Rauhigkeiten der Grabenwände werden als Hauptursache für unzureichende Durchbruchfestigkeit des Dielektrikums in Graben angesehen.

Ein Verfahren gemäß dem Oberbegriff, mit dem Gräben mit einstellbarer Steilheit der Grabenwände erzeugt werden können, ist in der deutschen Offenlegungsschrift DE-361 3181 A1 offenbart. Die Ätzung wird in einem Einscheibenplattenreaktor mit beheizten Elektroden in einer Ätzgasatmosphäre aus Trifluorbrommethan durchgeführt. Dabei ist vorgesehen, die Steilheit der Grabenwände bis maximal 90 $^\bullet$ durch Änderung der Hochfrequenzleistungsdichte zwischen 1 W/cm$^2$ und 3 W/cm$^2$ einzustellen, wobei der Gasfluß des Reaktionsgases auf mindestens 30 sccm eingestellt und der Gasdruck auf maximal 2 x 10$^{-2}$ mbar gehalten wird.

Aufgabe der Erfindung ist es, ein Verfahren anzugeben, mit dem Gräben, die senkrechté bis leicht abgeschrägte, glatte Wände und abgerundete Böden aufweisen, in Siliziumsubstraten zuverlässig und exakt reproduzierbar erzeugt werden können.

Diese Aufgabe wird durch ein Verfahren der eingangs genannten Art dadurch gelöst, daß
a) die Ätzgasatmosphäre aus einer Mischung aus Trifluorbrommethan und Stickstoff erzeugt wird und
b) die Ätzung in einem Einscheibenplattenreaktor durchgeführt wird.

Weitere Ausgestaltungen und Weiterbildungen der Erfindung gehen aus den Unteransprüchen sowie der nachfolgend anhand eines Ausführungsbeispiels gegebenen Beschreibung hervor.

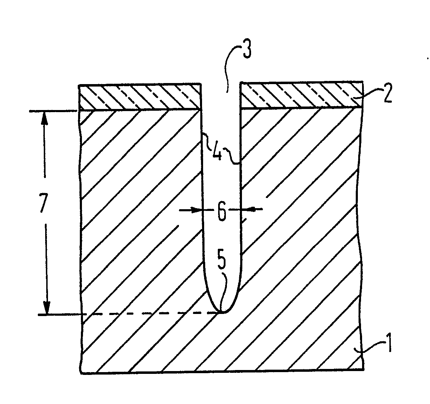

Die Figur zeigt einen gemäß der Lehre der Erfindung erzeugten Graben 3 in einem Siliziumsubstrat 1 als schematische Darstellung eines Ausschnittes einer Halbleiterscheibe. Es liegt im Rahmen der Erfindung, daß als Ätzmaske 2 eine mindestens 500 nm dicke, vorzugsweise 700 nm dicke, durch thermische Zersetzung aus Tetraethylorthosilikat (TEOS) erzeugte SiO$_2$-Schicht verwendet wird. Gemäß einem besonders günstigen Ausführungsbeispiel nach der Lehre der Erfindung wird das reaktive Ionenätzen in einem Trioden-Einscheibenplattenreaktor durchgeführt. Dieser Anlagentyp wird gleichzeitig mit zwei verschiedenen Hochfrequenzgeneratoren betrieben. Zur Erzeugung der reaktiven Ionen wird eine 13,56 MHz Hochfrequenz an einer ringförmigen Elektrode angelegt, die die zu ätzende Halbleiterscheibe umgibt. Die Elektrode, auf der sich die Scheibe befindet, wird mit einer 100 KHz Hochfrequenz versorgt, um die reaktiven Ionen zur Scheibe hin zu beschleunigen. Dadurch ist durch die Wahl der Prozeßparameter eine weitgehend unabhändige Einflußnahme auf die Ionendichte und die Ionenenergie möglich.

Im Einscheibenplattenreaktor wird eine Ätzgasatomosphäre aus Trifluorbrommethan (CBrF$_3$) und Stickstoff (N$_2$) mit einem CBrF$_3$-Gasfluß von 1,7 sccm und einem N$_2$-Gasfluß von 3 sccm und einem Gasdruck von 0,73 mbar eingestellt. Besonders gute Ergebnisse werden mit einer Ätzgasmischung erzielt, bei der der Stickstoffanteil größer als der Anteil des Trifluorbrommethan ist.

Die Hochfrequenzleistungsdichten betragen für die Frequenz von 13,56 MHz 500 W und für die Frequenz von 100 KHz 140 W.

Mit den obengenannten Prozeßparametern werden bei einer Ätzzeit von 6,5 Minuten Gräben 3 erhalten, die eine mittlere Grabenbreite 6 von ca. 0,75 um und eine Grabentiefe 7 von ca. 4,5 pm aufweisen. Dabei werden optimale Grabenprofile erhalten, d.h. die Grabenwände 4 sind senkrecht bis sehr leicht abgeschrägt, im unteren Bereich der Gräben 3 geht das Profil in einen halbkugelförmigen Grabenbogen 5 über und die Grabenwände 4 sind extrem glatt.

Prozeßparametervariationen zeigen, daß das Verfahren nach der Lehre der Erfindung ein im Vergleich zu Ätzverfahren ohne Stickstoff als Prozeßgasanteil ein wesentlich breiteres Prozeßfenster aufweisen. Das Verfahren zeichnet sich außerdem durch eine hohe Reproduzierbarkeit der erhaltenen Grabenprofile aus.

Es werden die folgenden Ätzraten für eine Halbleiterscheibe mit einem Durchmesser von 4 Zoll erhalten:

|  | Silizium-Ätzrate $\mu$m/min | Siliziumoxid-Ätzrate $\mu$m/min |
|---|---|---|
| Scheibenmitte: | 0,72 | 66 |
| Scheibenrand: | 0,70 | 75 |

Als besonderer Vorteil zeigt sich, daß der Unterschied der Grabenprofile in der Scheibenmitte und am Scheibenrand minimal ist verglichen mit den bisher bekannten Ätzprozessen. Die Grabenprofile in der Scheibenmitte und am Scheibenrand unterscheiden sich weder hinsichtlich der Profilform noch hinsichtlich der Grabentiefe merklich.

Die Selektivität der Siliziumätzung im Vergleich zur Ätzung der Siliziumoxidmaske beträgt dabei:

| Scheibenmitte: | 10,9 : 1 |
|---|---|
| Scheibenrand: | 9,3 : 1 |

Damit ergibt sich eine Homogenität des Oxidabtrages von ca. kleiner als ± 10 %.

Das Verfahren zeichnet sich durch eine hohe Reproduzierbarkeit der erhaltenen Grabenprofile aus. Die Grabenwände 4 sind dabei erheblich glatter als bei vergleichbaren Ätzverfahren, die ohne Verwendung von Stickstoff als Prozeßgasanteil durchgeführt werden.

Plasmainduzierte Redepositionen, das sind beim reaktiven Ionenätzen sich aus den verwendeten Stoffen bildende Ablagerungen in den Gräben, können durch bekannte naßchemische Ätzverfahren oder mittels eines Oxidplasmas entfernt werden.

Neben der Anwendung des Verfahrens zur Erzeugung von Gräben für die Herstellung von Grabenzellen für Halbleiterspeicher beinhaltet die Erfindung auch die Anwendung des Verfahrens zur Erzeugung von Gräben für die Isolation von CMOS-Bauelementen höchstintegrierter Schaltungen, bei denen Isolationstechniken wie das be kannte LOCOS-Verfahren durch die Grabenisolation (Box-Isolation) ersetzt werden muß.

**Ansprüche**

1. Verfahren zum Erzeugen von Gräben (3) in Siliziumsubstraten (1) für höchstintegrierte Halbleiterschaltungen durch reaktives Ionenätzen in einer Trifluorbrommethan enthaltenden Ätzgasatmosphäre unter Verwendung einer Ätzmaske (2), **dadurch gekennzeichnet** daß

a) die Atzgasatmosphäre aus einer Mischung aus Trifluorbrommethan und Stickstoff erzeugt wird und

b) die Ätzung in einem Einscheibenplattenreaktor durchgeführt wird.

2. Verfahren nach Anspruch 1, **dadurch gekennzeichnet** daß das Verhältnis der Gasflüsse von Trifluorbrommethan zu Stickstoff kleiner als 1 ist.

3. Verfahren nach Anspruch 1 oder 2, **dadurch gekennzeichnet** daß als Einscheibenplattenreaktor ein Trioden-Einscheibenplattenreaktor verwendet wird, wobei gleichzeitig zwei verschiedene Hochfrequenzen eingestrahlt werden.

4. Verfahren nach Anspruch 5, **dadurch gekennzeichnet** daß die Frequenzen der Hochfrequenzeinstrahlungen auf 13,56 MHz und 100 kHz eingestellt werden.

5. Verwendung des Verfahrens nach einem der Ansprüche 1 bis 4 zur Herstellung von Grabenzellen für Halbleiterspeicher mit dreidimensionalen Strukturen.

6. Verwendung des Verfahrens nach einem der Ansprüche 1 bis 4 zur Herstellung von die aktiven Transistorbereiche im Siliziumsubstrat trennenden Grabenisolationen von hochintegrierten CMOS-Schaltungen.

# EUROPÄISCHER RECHERCHENBERICHT

**Europäisches Patentamt**

Nummer der Anmeldung

EP 89 10 2914

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| Y | EXTENDED ABSTR., Band 87-2, 18.-23. Oktober 1987, Seiten 1038-1039, Nr. 726; H. UCHIDA et al.: "Submicron trench etching under high pressure (60 Pa)" * Spalte 1, Absätze 1,2; Spalte 2, Absatz 5; Figur 6 * | 1 | H 01 L 21/306 H 01 L 21/308 |
| A | IDEM --- | 3-6 | |
| Y | EP-A-0 203 560 (TEGAL CORP.) * Seite 1, Absatz 2; Seite 6, Absatz 2; Ansprüche 1,2 * | 1 | |
| A | --- | 3-6 | |
| A | US-A-3 984 301 (NIPPON ELECTRIC VARIAN) * Spalte 4, Zeilen 50-67; Ansprüche 1,4-6 * --- | 1 | |
| A | US-A-4 572 759 (D.W. BEURING) * Spalte 7, Zeile 48 - Spalte 8, Zeile 8 * --- | 1 | **RECHERCHIERTE SACHGEBIETE (Int. Cl.4)** H 01 L |
| A | DE-A-3 318 566 (HITACHI) * Ansprüche 1,4,5 * ----- | 1,2 | |

Der vorliegende Recherchenbericht wurde für alle Patentansprüche erstellt

| Recherchenort | Abschlußdatum der Recherche | Prüfer |
|---|---|---|
| DEN HAAG | 29-06-1989 | VANCRAEYNEST F.H. |

EPO FORM 1503 03.82 (P0403)